## Europäisches Patentamt

## European Patent Office

## Office européen des brevets

(19)

(11) Veröffentlichungsnummer: **0 008 354**
**B1**

(12) **EUROPÄISCHE PATENTSCHRIFT**

(45) Veröffentlichungstag der Patentschrift:
**06.01.82**

(21) Anmeldenummer: **79102416.9**

(22) Anmeldetag: **12.07.79**

(51) Int. Cl.³: **G 11 C 19/28**, G 11 C 27/02,
H 01 L 27/10

(54) Ladungsverschiebespeicher in Seriell-Parallel-Seriellorganisation mit streng periodischer Taktansteuerung.

(30) Priorität: **17.08.78 DE 2836080**

(43) Veröffentlichungstag der Anmeldung:
**05.03.80 Patentblatt 80/5**

(45) Bekanntmachung des Hinweises auf die Patenterteilung:
**06.01.82 Patentblatt 82/1**

(84) Benannte Vertragsstaaten:
**FR GB NL**

(73) Patentinhaber: **SIEMENS AKTIENGESELLSCHAFT** Berlin
und München, Postfach 22 02 61, D-8000 München 22 (DE)

(72) Erfinder: **Feitl, Helmut, Dr., Idastrasse 13,
D-8000 München 71 (DE)**

(56) Entgegenhaltungen:
DE-A-3 518 017
NL-A-7 316 277
US-A-3 763 480
US-A-3 885 167
US-A-3 889 245
US-A-3 913 077
US-A-3 944 990
US-A-3 967 254
US-A-4 007 446
US-A-4 024 514
US-A-4 065 756

CHARGE TRANSFER DEVICES, ACADEMIC PRESS 1975, New York, US
SEQUIN & TOMPSETT: »Digital Memories« Seiten 236 bis 301
IEEE JOURNAL OF SOLID-STATE CIRCUITS, vol. SC 9, No. 6, Dezember 1974, New York, US
KRAMBECK et al.: »A 4160-Bit CHD Serial Memory« Seiten 436 bis 443
IEEE EUROPEAN SOLID-STATE CIRCUITS CONFERENCE, 2—5 September 1975, London (GB)
GOTTLET et al.: »CCD Memory Circuits of High Bit Density« Seiten 76 bis 77

## Ladungsverschiebespeicher in Seriell-Parallel-Seriellorganisation mit streng periodischer Taktansteuerung

Die Erfindung betrifft einen Ladungsverschiebespeicher, bei dem eine Einlesekette aus jeweils abwechselnd hintereinander angeordneten ersten und zweiten Ladungsverschiebeelementen vorgesehen ist und bei dem der Einlesekette ein Feld von Parallelketten von Ladungsverschiebeelementen zugeordnet ist, in die die Information kennzeichnende Ladungen aus der Einlesekette übernommen werden und bei dem eine Auslesekette aus jeweils abwechselnd hintereinander angeordneten ersten und zweiten Ladungsverschiebeelementen vorgesehen ist, in die die Ladungen aus den Parallelketten übergeben werden.

Ladungsverschiebespeicher in sogenannter verdichteter Seriell-Parallel-Serielltechnik, wie sie z. B. in der DE-OS 2 551 797 bzw. 2 518 017 beschrieben werden, bestehen aus einer seriell angeordneten Einlesekette aus Ladungsverschiebeelementen, einer unter jeder Speicherelektrode dieser Seriellkette angeordneten Parallelkette aus Ladungsverschiebeelementen und einer weiteren seriell angeordneten Auslesekette. Durch eine derartige Organisation kann eine sehr hohe Speicherdichte erzielt werden.

Wie aus den zitierten Offenlegungsschriften ersichtlich, ist das Taktprogramm zur Ansteuerung eines derartig organisierten Speichers relativ kompliziert. Da nur unter jeder zweiten Speicherelektrode Information enthalten ist, muß die serielle Kette zweimal eingelesen werden und es muß die Information zweimal in das Parallelfeld übernommen werden. Bei der Übernahme steht die Information das erstemal unter den ungeraden Speicherelektroden, das zweitemal unter den geraden. Damit muß die zweite Übernahme um einen Schiebetakt versetzt erfolgen, was das Taktprogramm ungerade macht, d. h. die Übernahmetakte kommen nicht in gleichen Abständen, sondern sind etwas gegeneinander versetzt. Die Erzeugung derartiger ungeraden Übernahmetakte ist aber insgesamt recht aufwendig.

Ladungsverschiebespeicher mit der angegebenen Organisationsform können wie alle derartigen Ladungsverschiebespeicher als Zweiphasen-Ladungsverschiebespeicher oder 4-Phasen-Ladungsverschiebespeicher ausgelegt sein. Es ist ebenso möglich, 4-Phasen-Ladungsverschiebespeicher im 2-Phasen-Betrieb zu betätigen. Die im folgenden getätigten Überlegungen gelten für einen 4-Phasen-Ladungsverschiebespeicher, der im 2-Phasen-Betrieb betätigt wird, einer Betriebsweise, bei der jede zweite Elektrode (Speicherelektrode) zeitgleich mit der benachbarten (Transfer) Elektrode angesteuert wird. Als Ladungsverschiebeelement wird dabei ein Element definiert, das sich aus Speicher- und Transferelektrode zusammensetzt. Selbstverständlich gelten die analogen Überlegungen auch für einen echten 2-Phasen-Ladungsverschiebespeicher, in diesem Fall werden als Ladungsverschiebeelemente die elektrisch verbundenen Transfer- und Speichergates definiert, oder für reinen 4-Phasen-Betrieb bei dem die Transfer- und Speichergates getrennt angesteuert werden.

Aufgabe der Erfindung ist die Bereitstellung eines Ladungsverschiebespeichers in verdichteter Seriell-Parallel-Seriellorganisation, der in einfacher und kostengünstiger Weise mit einem streng periodischen Taktprogramm angesteuert werden kann.

Diese Aufgabe wird gemäß der Erfindung dadurch gelöst, daß jedem der ersten oder zweiten Ladungsverschiebeelemente der Ein- und Auslesekette mindestens eine Gruppe von zwei mit Übernahme- bzw. Übergabeelektroden versehene, benachbarte Parallelketten von Ladungsverschiebeelementen zugeordnet ist.

Dadurch, daß die Information definierende Ladung immer aus den gleichen Speicherelektroden übernommen und abwechselnd in zwei benachbarte Parallelketten weitergegeben wird, wird das dazu erforderliche Ansteuertaktprogramm streng periodisch.

Bei einer besonders vorteilhaften Ausführungsform der Erfindung sind jedem Ladungsverschiebeelement zwei Gruppen von Parallelketten zugeordnet. Zwischen den einzelnen Gruppen von Parallelketten und den zugeordneten Ladungsverschiebeelementen der Ein- bzw. Auslesekette ist jeweils eine erste Zwischenstufe aus einem Ladungsverschiebeelement vorgesehen.

Das Einführen in derartigen zusätzlichen Verzweigungsstufen im Parallelfeld hat neben der streng periodischen Ansteuerung den Vorteil, daß hardwaremäßig betrachtet, die Packungsdichte im Parallelfeld nicht mehr durch das Rastermaß der seriellen Eingangskette bestimmt wird, sondern durch den kleineren Minimalabstand der Parallelketten von Ladungsverschiebeelementen. Dadurch ergibt sich eine wesentlich erhöhte Packungsdichte.

Die eben geschilderten Vorteile lassen sich auch erzielen, wenn bei der Erfindung eine weitere, zweite Zwischenstufe vorgesehen ist, die jeweils zwei mit der ersten Zwischenstufe an diese zweite Zwischenstufe angeknüpfte Parallelketten mit den zugeordneten Ladungsverschiebeelementen der Ein- bzw. Auslesekette verbindet.

Die Erfindung wird nachstehend anhand der in den Zeichnungen dargestellten Ausführungsformen erläutert. Es zeigen

Fig. 1 und 2 eine schematische Darstellung eines verdichteten Seriell-Parallel-Seriell-CCD-Speicherbausteins mit zugehörigem Taktprogramm,

Fig. 3 und 4 eine schematische Darstellung eines verdichteten Seriell-Parallel-Seriell-CCD-Speicherbausteins gemäß der Erfindung mit streng periodischem Taktprogramm,

Fig. 5 und 6 eine schematische Darstellung eines verdichteten Seriell-Parallel-Seriell-CCD-Speicherbausteins mit zugehörigem Taktprogramm für zweistufige Übernahme mit einer Zwischenstufe,

Fig. 7 eine schematische Darstellung eines Ausschnitts eines Speicherbausteins gemäß Fig. 3 mit einstufiger Übernahme,

Fig. 8 eine schematische Darstellung eines Ausschnitts eines Speicherbausteins gemäß Fig. 5 mit zweistufiger Übernahme,

Fig. 9 eine schematische Darstellung eines Ausschnitts eines Speicherbausteins gemäß Fig. 5 mit zweistufiger Übernahme ohne Kontakte im Speicherfeld,

Fig. 10 und 11 eine schematische Darstellung eines verdichteten Seriell-Parallel-Seriell-CCD-Speicherbausteins mit zweistufiger Übernahme, bei dem jedem zweiten Ladungsverschiebeelement der Ein- und Auslesekette zwei Gruppen von Parallelketten zugeordnet sind,

Fig. 12 eine schematische Darstellung eines Ausschnitts eines verdichteten Seriell-Parallel-Seriell-CCD-Speicherbausteins mit zweistufiger Übernahme gemäß Fig. 10, 11 mit größtmöglicher Packungsdichte,

Fig. 13 und 14 eine schematische Darstellung eines verdichteten Seriell-Parallel-Seriell-CCD-Speicherbausteins mit dreistufiger Übernahme mit zwei Zwischenstufen.

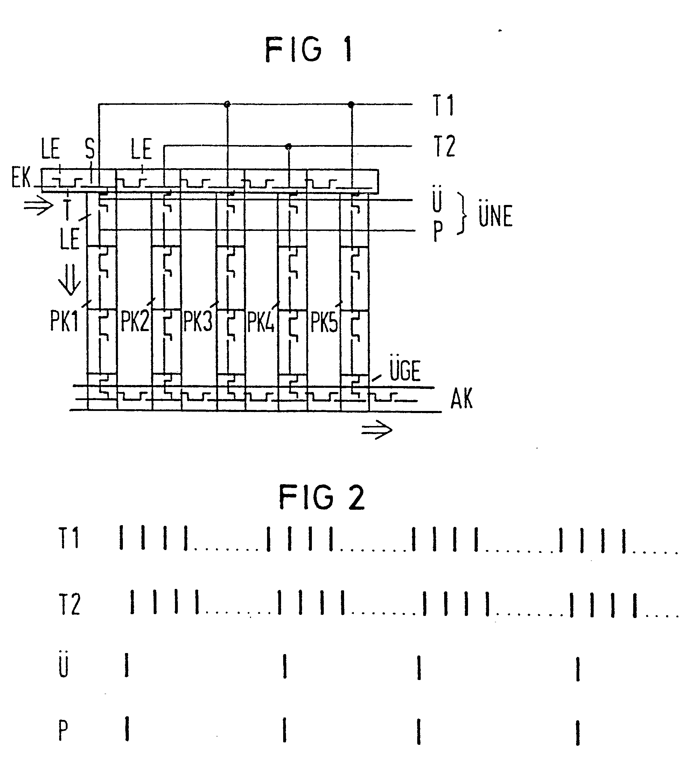

Bei dem in der Fig. 1 mit zugehörigem Taktprogramm der Fig. 2 dargestellten, verdichteten Seriell-Parallel-Seriell-Ladungsverschiebespeicherbaustein, wie er in der DE-OS 2 551 797 bzw. der DE-OS 2 518 017 beschrieben wird, handelt es sich um einen sogenannten 4-Phasen-Ladungsverschiebespeicher im 2-Phasen-Betrieb. Er besteht im wesentlichen aus einer Einlesekette EK, einer zugeordneten Parallelkette PK und einer nachgeschalteten Auslesekette AK. Bei dieser Betriebsweise wird als Ladungsverschiebeelement LE ein Element bezeichnet, das sich aus einer Speicherelektrode S und einer Transferelektrode T zusammensetzt. Bei einem derartigen 4-Phasen-CCD in 2-Phasen-Betrieb, wird die Speicherelektrode zugleich mit der benachbarten Transferelektrode angesteuert. Selbstverständlich gelten die folgenden Überlegungen auch für reine 2-Phasen-CCD-Speicherbausteine.

Zur Funktion eines derartigen verdichteten Ladungsverschiebespeicherbausteins in Seriell-Parallel-Serielltechnik wird auf die zitierten Offenlegungsschriften verwiesen.

Der Takt T1 bezeichnet einen Einlesetakt hoher Frequenz für die Einlesekette EK und der Takt T2 einen zweiten Einlesetakt, der gegenüber dem ersten Takt T1 phasenverschoben ist, jedoch die gleiche Frequenz aufweist. Die Übernahme in das Parallelfeld PK erfolgt durch die Takte Ü und P des Übernahmeelements ÜNE.

Da beim Einlesen in den Speicherbaustein nur unter jeder zweiten Speicherelektrode Information enthalten ist, muß die serielle Kette EK zweimal eingelesen werden und es muß zweimal in das Parallelfeld PK übernommen werden. Bei der Übernahme steht die Information das erste Mal unter den ungeraden Speicherelektroden und das zweite Mal unter den geraden. Die zweite Übernahme muß also um einen Schiebetakt versetzt erfolgen (Fig. 2). Ein derartiger Speicheraufbau macht das Taktprogramm »ungerade«, entsprechend der Darstellung in Fig. 2. Die identischen Übernahmetakte Ü und P kommen nicht in gleichen Abständen, sondern sind etwas gegeneinander versetzt. Dadurch wird das Taktprogramm für die Übernahmetakte nicht streng periodisch. Die Erzeugung derartiger ungerader Übernahmetakte ist aber insgesamt recht aufwendig.

Bei den beschriebenen verdichteten Seriell-Parallel-Seriell-CCD-Speicherbausteinen können die Speicherelektroden der seriellen Ketten nach zwei Richtungen übergeben (Eingabe über das Übernahmeelement ÜNE) bzw. aus zwei Richtungen übernehmen (Ausgabe über das Übergabeelement ÜGE). Das »ungerade« Taktprogramm entsteht dadurch, daß abwechselnd die gerad- und die ungeradzahligen Speicherelektroden übergeben bzw. übernehmen.

Im folgenden ist das Taktprogramm nur für die Eingabe in die Parallelkette PK dargestellt. Die Ausgabe in die Ausgabekette AK erfolgt in analoger Weise.

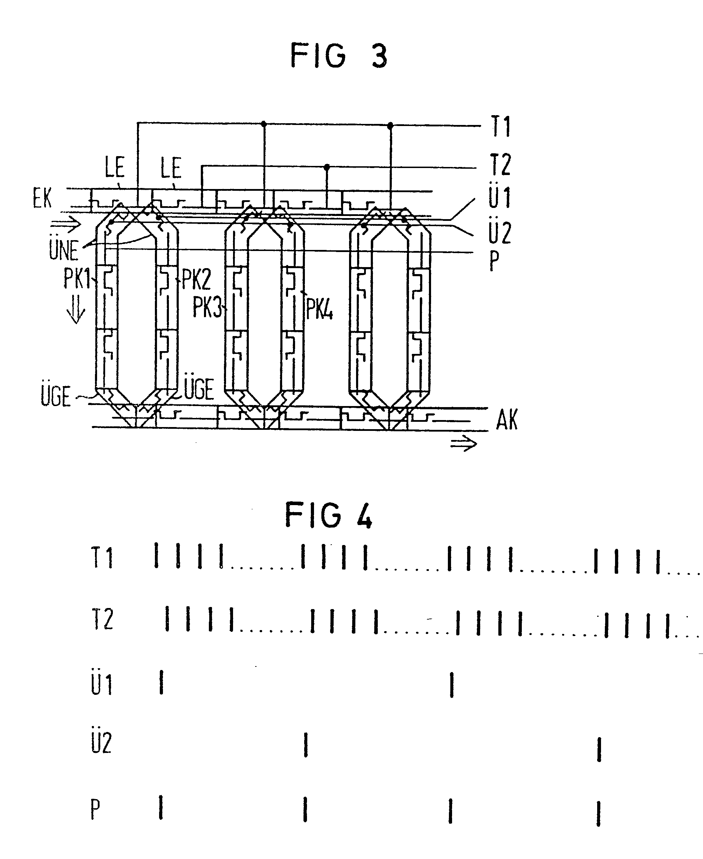

Ordnet man gemäß der Erfindung jedem ersten Ladungsverschiebeelement der Ein- und Auslesekette EK, AK mindestens eine Gruppe von zwei mit Übernahme- bzw. Übergabeelektroden ÜNE, ÜGE versehene benachbarte Parallelketten PK1 und PK2 von Ladungsverschiebeelementen zu, so wird das zugehörige Taktprogramm für die Übernahmetakte Ü1 und Ü2, entsprechend der Darstellung der Fig. 4, streng periodisch. Das bedeutet, der Übernahmetakt Ü2 liegt exakt in der Mitte zwischen dem Übernahmetakt Ü1. Bei dieser Ausführungsform hat jedes der ersten Ladungsverschiebeelemente der Ein- und Auslesekette drei Ausgänge, nämlich einen in die serielle Kette EK und je einen in zwei Ketten des Parallelfeldes PK1 und PK2. Die Speicherelektroden der seriellen Ausgangskette AK haben entsprechend drei Eingänge.

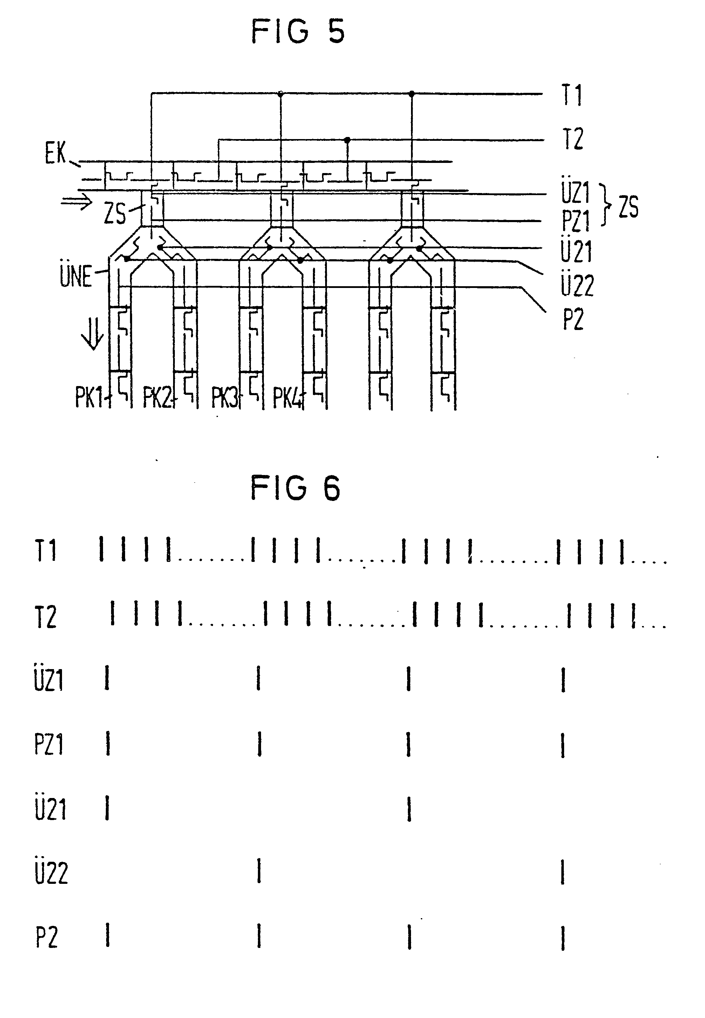

Eine weitere Möglichkeit, eine streng periodische Taktansteuerung zu erreichen, ist in den Fig. 5 und 6 dargestellt. Bei dieser Ausführungsform der Erfindung ist jeweils zwischen den einzelnen Gruppen von Parallelketten PK1, PK2 bzw. PK3, PK4 etc. und den zugeordneten Ladungsverschiebeelementen EK bzw. AK der Ein- bzw. Auslesekette eine erste Zwischenstufe ZS mit den Takten ÜZ1 bzw. PZ1 angeordnet.

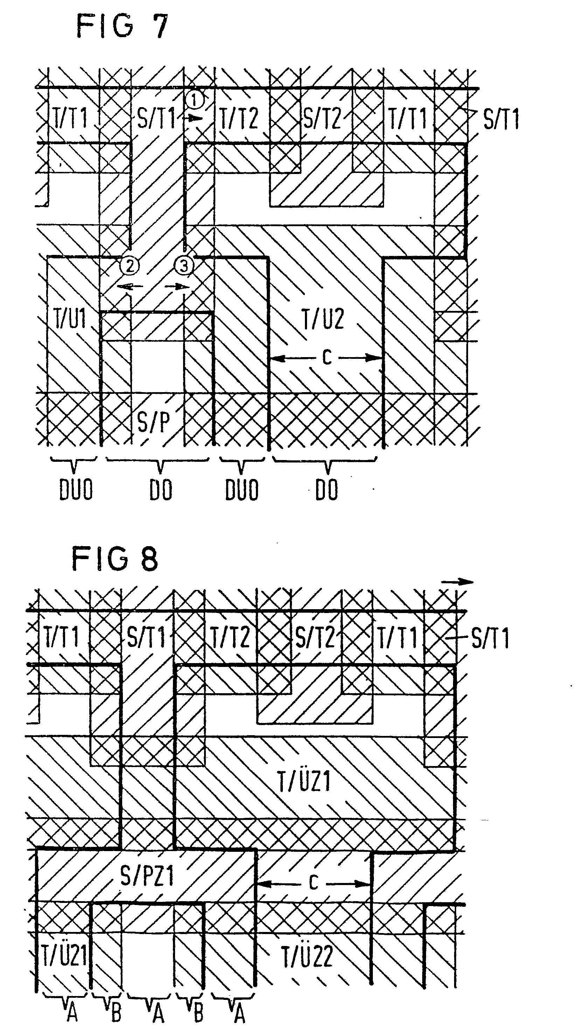

Die Fig. 7 zeigt eine schematische Darstellung eines Ausschnittes des Speicherbausteins entsprechend der Fig. 3 mit einstufiger Übernahme. Die Flächen T/T und S/T1 bezeichnen dabei die über die Takte T1 angesteuerten Ladungsverschiebeelemente der Einlesekette EK mit ihren Speicherelektroden S (rechtsläufig schraffiert) und ihren Transferelektroden T (linksläufig schraffiert). Die Flächen T/T2 und S/T2 bezeichnen analog dazu die mit dem Takt T2 angesteuerten Speicherelektroden S und Transferelektroden T der Ladungsverschiebeelemente der Einlesekette EK. Analog dazu gilt für die Übernahmeelemente die Bezeichnung T/Ü1 und T/Ü2 und S/P. Die Transferelektroden T/Ü1, T/Ü2 der Übernahmeelemente aus Polysilizium 2 sind mit hier nicht dargestellten Aluminiumleitungen kontaktiert.

Die Kontaktierung der Elektroden kann auf Gebieten erfolgen, unter denen noch Polysilizium 1 (Speichergate S) und/oder Dickoxyd DO liegt. Die drei Ausgänge der Speicherelektrode S eines jeden ersten Ladungsverschiebeelementes LE der Einlesekette EK sind mit 1, 2 und 3 bezeichnet. Die Pfeile bezeichnen die Verschieberichtung. Die dick eingezeichneten Linien bezeichnen die Übergänge vom dünnen zum dicken Oxyd (DO). Der innerhalb der Linien liegende Bereich DÜO ist der Bereich des dünnen Oxydes. Zur Technologie wird auf das Buch »Datenspeicher«, K. Kaufmann, Oldenburg München – Wien 1973, Seite 174 ff. verwiesen.

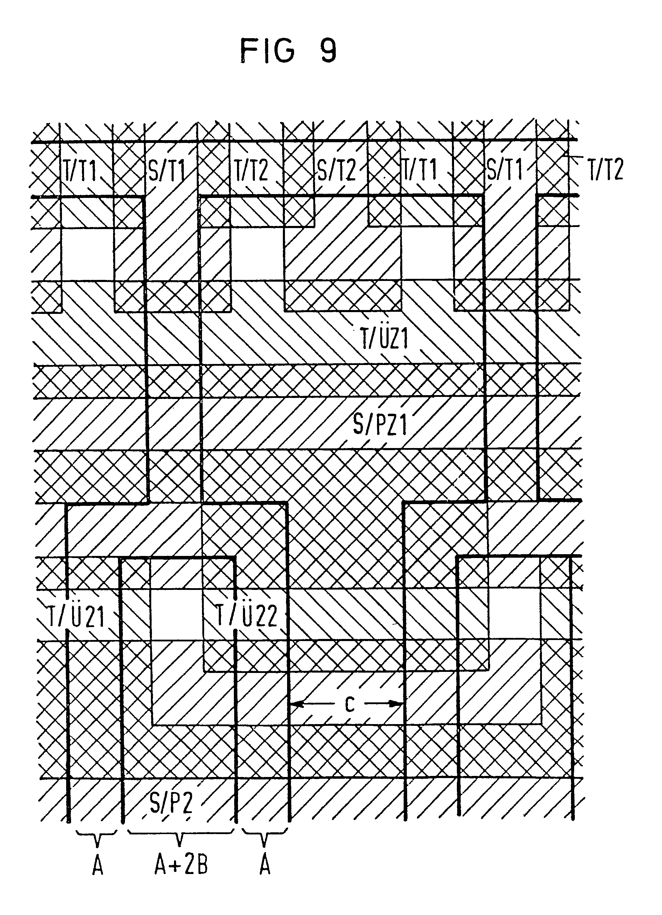

Die Fig. 8 zeigt eine schematische Darstellung eines Ausschnitts eines Speicherbausteins gemäß der Darstellung der Fig. 5 mit zweistufiger Übernahme. Die Abb. 9 zeigt eine anloge Ausführung zu der Fig. 5 mit zweistufiger Übernahme, bei der die Kontaktierung der Übernahmeelektroden untereinander so erfolgen kann, daß keine Kontakte im Speicherfeld erforderlich sind.

Wie aus den Fig. 7 bis 9 ersichtlich ist, benötigen die zwei Übergabeelektroden in serieller Richtung T/Ü1, T/Ü2 bzw. T/Ü21, T/Ü22 nur einen Raum von $3 \times A + 2B$. A bezeichnet dabei das minimale Strukturmaß (Abstand zwischen 2 Transferelektroden bzw. Speicherelektroden) und B jene Überlappung, die notwendig ist, um Fehler infolge der unvermeidbaren Verjustierungen der Masken auszuschließen. Da es möglich ist, zwei Verzweigungselektroden zusammenzufassen, fallen bei zwei benachbarten Parallelketten die Überlappungen weg. Bezeichnet man mit C den Minimalabstand von zwei Parallelketten von Ladungsverschiebeelementen, so ergibt sich ein Rastermaß von

$3/2 \times A + B + \dfrac{C}{2}$. Das ist günstiger als das bei dem Stand der Technik übliche Rastermaß von

$2 \times A + 2 \times B$, was für verdichtete Seriell-Parallel-Seriell-Ladungsverschiebespeicher gilt. C muß dabei natürlich kleiner als $A + 2 \times B$ sein, wobei als Minimalwert $C = A$ ist. Das Rastermaß wird in diesem Fall dann $2 \times A + B$. Ein solches Rastermaß von $2 \times A + B$ ist aber mit einer rein seriellen Eingabe (Rastermaß $2 \times A + 2 \times B$) nicht erreichbar. Mit einer mehrstufigen Übergabe lassen sich jedoch die parallelen Kanäle in minimalem Abstand anordnen, denn es ist jetzt nicht mehr das Rastermaß der seriellen Eingangskette ausschlaggebend, sondern der Platzbedarf der verzweigenden Übernahmeelektroden.

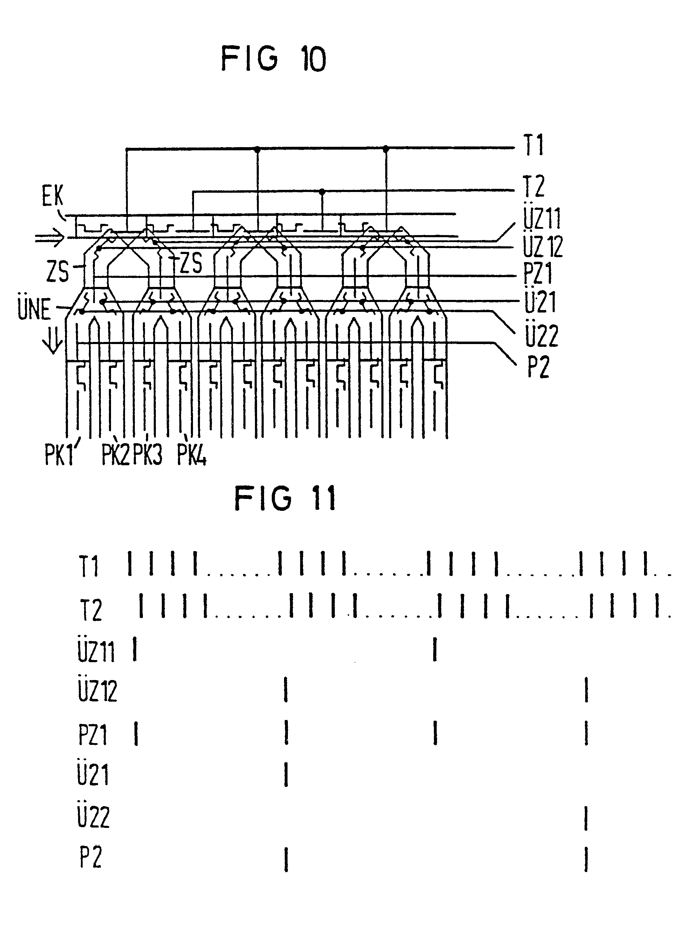

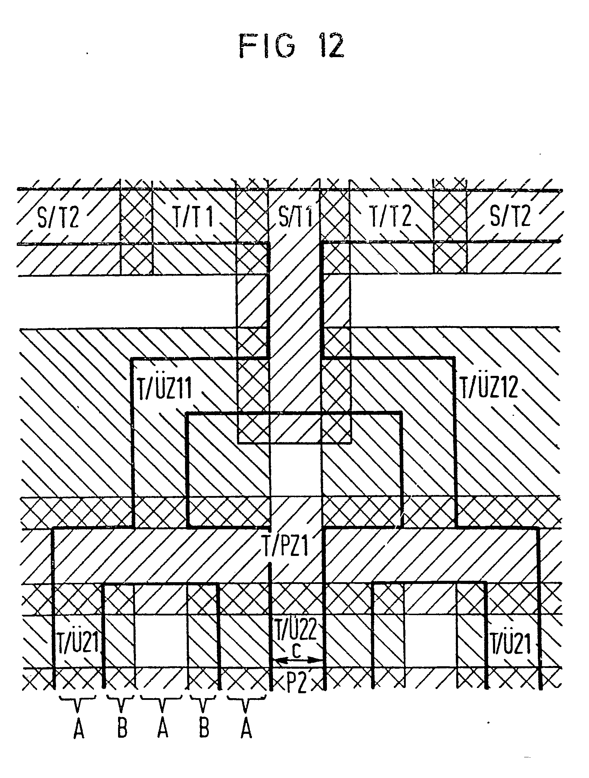

Bei der in der Fig. 10 mit ihrem Taktprogramm der Fig. 11 dargestellten Ausführungsform eines verdichteten Seriell-Parallel-Seriell-CCD-Speicherbausteines mit zweistufiger Übernahme, bei dem jedem der ersten Ladungsverschiebeelemente der Ein-/Auslesekette zwei Gruppen von Parallelketten zugeordnet sind, wird erreicht, daß nicht das Rastermaß der seriellen Ketten, sondern der kleinere Minimalabstand der parallelen Ketten von Ladungsverschiebeelementen die bestimmte Größe wird. Die Fig. 12 zeigt dabei eine mögliche Ausführungsform der Fig. 10. Aus dieser Figur ist ersichtlich, daß genügend Platz vorhanden ist, um die Übernahmeelektroden T/ÜZ11 und T/ÜZ12 der ersten Zwischenstufe ZS auf dem Dickoxyd zu kontaktieren. Die Übernahmeelektroden T/Ü21 und T/Ü22 der Übernahmeelemente ÜNE können auf Gebieten kontaktiert werden, unter denen Polysilizium 1 liegt, oder es wird eine kontaktlose Ausführung in Kammform analog zu der Fig. 7 gewählt. Mit dieser Organisation wird die größtmögliche Packungsdichte erreicht. In diesem Fall ist der minimale Abstand zwischen 2 Parallelketten C identisch mit dem Rastermaß A.

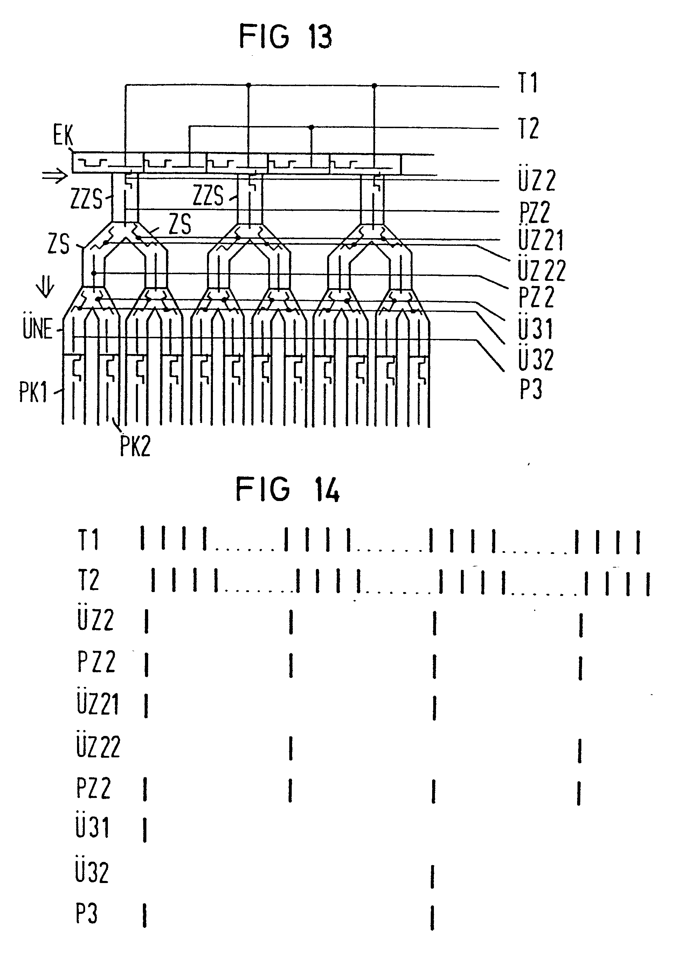

Die Fig. 13 zeigt eine Ausführungsform eines verdichteten Seriell-Parallel-Seriell-Ladungsverschiebespeichers, bei dem eine weitere, zweite Zwischenstufe ZZS vorgesehen ist, die jeweils zwei mit der ersten Zwischenstufe ZS an diese zweite Zwischenstufe ZZS angeküpfte Parallelketten mit den zugeordneten Ladungsverschiebeelementen der Ein- bzw. Auslesekette verbindet. Durch diesen Aufbau wird eine dreistufige Übernahme erreicht. Entsprechend der Fig. 5, mit dem Taktprogramm der Fig. 6, wird aus der seriellen Eingangskette EK in eine weitere zweite Zwischenstufe ZZS übernommen und dann in den ersten Zwischenstufen ZS verzweigt, so daß wieder der minimal mögliche Abstand der parallelen Ladungsverschiebeketten für die Packungsdichte ausschlaggebend wird.

Durch die Erfindung wird in vorteilhafter Weise bei verdichteten Seriell-Parallel-Seriell-Ladungsverschiebespeicherbausteinen erreicht, daß diese streng periodisch angesteuert werden können. Das Einführen einer zusätzlichen Verzweigungsstufe ergibt einen weiteren Vorteil; die Packungsdichte im Parallelfeld ist nun nicht mehr durch das Rastermaß der seriellen Eingangskette bestimmt, sondern durch den kleineren Minimalabstand der Parallelketten.

Liste der Bezugszeichen

| | |
|---|---|
| EK | Einlesekette |
| PK1 . . . PK5 | Parallelkette |
| AK | Auslesekette |
| LE | Ladungsverschiebeelement |
| T1 | erster Einlesetakt |
| T2 | zweiter Einlesetakt |
| Ü, Ü1, Ü2 | Übernahmetakt |
| P | Übernahmetakt |
| ÜNE | Übernahmeelement |
| ÜGE | Übergabeelement |
| ZS | erste Zwischenstufe |
| ÜZ1 | Übernahmetakt |
| PZ1 | Übernahmetakt |
| Ü21 | Übernahmetakt |
| Ü22 | Übernahmetakt |
| P2 | Übernahmetakt |
| T/T1 | Transfergate über Takt T1 angesteuert |
| T/T2 | Transfergate über Takt T2 angesteuert |
| S/T1 | Speichergate über Takt T1 angesteuert |
| S/T2 | Speichergate über Takt T2 angesteuert |
| 1, 2, 3 | Ausgänge der Speicherelektrode S |
| DO | Dickoxyd |
| DÜO | dünnes Oxyd |
| T/Ü1 | Transfergate über Takt Ü1 angesteuert |
| T/Ü2 | Transfergate über Takt Ü2 angesteuert |
| S/P | Speichergate über Takt P angesteuert |
| S/P2 | Speichergate über Takt P2 angesteuert |
| T/Ü21 | Transfergate über Takt Ü21 angesteuert |
| T/Ü22 | Transfergate über Takt Ü22 angesteuert |
| T/ÜZ1 | Transfergate über Takt ÜZ1 angesteuert |
| S/P21 | Speichergate über Takt PZ1 angesteuert |
| A | minimales Strukturmaß |
| B | Überlappung |
| C | Minimalabstand |
| ÜZ11 | Übernahmetakt |
| ÜZ12 | Übernahmetakt |
| T/ÜZ11 | Transfergate über Takt ÜZ11 angesteuert |
| T/ÜZ12 | Transfergate über Takt ÜZ12 angesteuert |
| ZZS | zweite Zwischenstufe |
| ÜZ2 | Übernahmetakt |
| PZ2 | Übernahmetakt |
| ÜZ21 | Übernahmetakt |
| ÜZ22 | Übernahmetakt |
| Ü31 | Übernahmetakt |
| Ü32 | Übernahmetakt |
| P3 | Übernahmetakt |

## Patentansprüche

1. Ladungsverschiebespeicher, bei dem eine Einlesekette (EK) aus jeweils abwechselnd hintereinander angeordneten ersten und zweiten Ladungsverschiebeelementen (LE) vorgesehen ist und bei dem der Einlesekette ein Feld von Parallelketten von Ladungsverschiebeelementen zugeordnet ist, in die die Information kennzeichnenden Ladungen aus der Einlesekette übernommen werden und bei dem eine Auslesekette (AK) aus jeweils abwechselnd hintereinander angeordneten ersten und zweiten Ladungsverschiebeelementen vorgesehen ist, in die die Ladungen aus den Parallelketten übergeben werden, dadurch gekennzeichnet, daß jedem der ersten oder zweiten Ladungsverschiebeelementen (LE) der Ein- und Auslesekette (EK, AK) mindestens eine Gruppe (PK1, PK2) von zwei mit Übernahme- bzw. Übergabeelektroden (ÜNE, ÜGE) versehene benachbarte Parallelketten von Ladungsverschiebeelementen zugeordnet ist.

2. Ladungsverschiebespeicher nach Anspruch 1, dadurch gekennzeichnet, daß jeweils zwischen den einzelnen Gruppen (PK1, PK2) von Parallelketten und den zugeordneten Ladungsverschiebeelementen der Ein- bzw. Auslesekette eine erste Zwischenstufe (ZS) aus einem Ladungsverschiebeelement angeordnet ist.

3. Ladungsverschiebespeicher nach Anspruch 2, dadurch gekennzeichnet, daß jedem ersten bzw. zweiten Ladungsverschiebeelement der Ein- und Auslesekette (EK, AK) zwei Gruppen von Parallelketten (PK) zugeordnet sind.

4. Ladungsverschiebespeicher nach Anspruch 3, dadurch gekennzeichnet, daß eine weitere, zweite Zwischenstufe (ZZS) vorgesehen ist, die jeweils zwei mit der ersten Zwischenstufe (ZS) an diese zweite Zwischenstufe (ZZS) angeknüpfte Parallelketten (PK) mit den zugeordneten Ladungsverschiebeelementen der Ein- bzw. Auslesekette (EK, AK) verbindet.

**Claims**

1. A charge transfer device comprising a read-in chain (EK) consisting of an alternating sequence of first and second charge shifting elements (LE) assigned a field of parallel chains of charge shifting elements into which the charges from the read-in chain which characterise the information are transferred into a read-out chain (AK) consisting of an alternating sequence of first and second charge shifting elements, characterised in that each said first or second charge shifting element (LE) of the read-in and read-out chain (EK, AK) is assigned at least one group (PK1, PK2) of two adjacent parallel chains of charge shifting elements each provided with respective transfer-in and feed-out electrodes (ÜNE, ÜGE).

2. A charge transfer device as claimed in claim 1, characterised in that there are arranged respective first intermediate stages (ZS) in the form of a charge shifting element between each individual group (PK1, PK2) of parallel chains and the assigned charge shifting element of the read-in chain and between each individual group of parallel chains and the assigned charge shifting element of the read-out chain.

3. A charge transfer device as claimed in claim 2, characterised in that each said first or second charge shifting element of the read-in chain and of the read-out chain (EK, AK) is assigned two groups of parallel chains (PK).

4. A charge transfer device as claimed in claim 3, characterised in that respective further second intermediate stages (ZZS) are provided to connect two parallel chains (PK) linked to this second intermediate stage (ZZS) by a said first intermediate stage (ZS) to the assigned charge shifting elements of the read-in chain and read-out chain (EK, AK) respectively.

**Revendications**

1. Mémoire à transfert de charge, dans laquelle il est prévu une chaîne d'inscription (EK) constituée par des premiers et seconds éléments à transfert de charge (LE) disposés alternativement les uns derrière les autres, et dans laquelle à la chaîne d'inscription est associé un ensemble de chaîne parallèles d'éléments à transfert de charge, dans lesquels des charges caractérisant l'information sont prises en charge à partir de la chaîne d'inscription et dans laquelle il est prévu une chaîne de lecture (AK) constituée par des premiers et des seconds éléments de transfert de charge disposés alternativement les uns derrière les autres et dans laquelle les charges sont transférées à partir des chaînes parallèles, caractérisée en ce qu'à chacun des premiers ou seconds éléments à transfert de charge (LE) de la chaîne d'inscription et de la chaîne de lecture (EK, AK) est associé au moins un groupe (PK1, PK2) de deux chaînes parallèles voisines, munies d'électrodes de prise en charge et de transfert (ÜNE, ÜGE), d'éléments à transfert de charge.

2. Mémoire à transfert de charge selon la revendication 1, caractérisée en ce qu'un premier étage intermédiaire (ZS) constitué par un élément à transfert de charge est disposé respectivement entre les différents groupes (PK1, PK2) de chaînes parallèles et les éléments associés à transfert de charge de la chaîne d'inscription et de la chaîne de lecture.

3. Mémoire à transfert de charge selon la revendication 2, caractérisée en ce qu'à chaque premier et second éléments à transfert de charge de la chaîne d'inscription et de la chaîne de lecture (EK, AK) sont associés deux groupes de chaînes parallèles (PK).

4. Mémoire à transfert de charge selon la revendication 3, caractérisée en ce qu'il est prévu un second étage intermédiaire supplémentaire (ZZS) qui relie respectivement deux chaînes parallèles (PK), raccordées par le premier étage intermédiaire (ZS) au second étage intermédiaire (ZZS), aux éléments associés à transfert de charge de la chaîne d'inscription et de la chaîne de lecture (EK, AK).

# FIG 1

# FIG 2

7

# FIG 3

# FIG 4

# FIG 5

# FIG 6

## FIG 7

## FIG 8

# FIG 9

# FIG 10

EK

T1
T2
ÜZ11
ÜZ12
ZS — ZS — PZ1
ÜNE — Ü21
Ü22
P2

PK1 PK2 PK3 PK4

# FIG 11

| | | | | | | | | | | | | | | | | | | |
|---|---|---|---|---|---|---|---|---|---|---|---|---|---|---|---|---|---|---|

T1  | | | | ...... | | | | ...... | | | | ...... | | | | ...
T2   | | | | ...... | | | | ...... | | | | ...... | | | | ..
ÜZ11 |                    |
ÜZ12        |                         |
PZ1  |      |          |          |
Ü21         |
Ü22                              |
P2          |                     |

# FIG 12

# FIG 13

# FIG 14